# EUROPEAN PATENT SPECIFICATION

(11) **EP 2 423 353 B1**
(45) Date of publication and mention of the grant of the patent: **08.05.2013**
(21) Application number: 11179525.8
(22) Date of filing: 31.08.2011
(51) Int. Cl.: C23C 16/509, C23C 16/54

(54) **Film deposition device**
Filmablagerungsvorrichtung
Dispositif de dépôt de film

(30) Priority: 31.08.2010 JP 2010194238
(43) Date of publication of application: 29.02.2012
(73) Proprietor: Fujifilm Corporation, Minato-ku Tokyo (JP)
(72) Inventor: Mochizuki, Yoshihiko, Kanagawa (JP); Tonohara, Kouji, Kanagawa (JP)
(74) Representative: HOFFMANN EITLE

(56) References cited:
- JP-A- 2010 111 900
- JP-A- 2010 121 159

## Description

### BACKGROUND OF THE INVENTION

The present invention relates to a film deposition device in which a film is formed by plasma CVD as a long strip of substrate travels in its longitudinal direction.

Various functional films (functional sheets) including gas barrier films, protective films, and optical films such as optical filters and antireflection films are used in various devices including optical devices, display devices such as liquid crystal display devices and organic EL display devices, semiconductor devices, and thin-film solar batteries.

Plasma CVD is employed to manufacture these functional films.

Continuous deposition of a film on a long strip of substrate (a web of substrate) traveling in the longitudinal direction is preferred for efficient plasma CVD film formation with high productivity.

A typical device known in the art for performing such a film deposition method is a so-called roll-to-roll film deposition device in which a long strip of substrate is fed from a substrate roll into which the substrate is wound and the substrate having a film formed thereon is wound into a roll.

This roll-to-roll film deposition device continuously forms a film on the long strip of substrate in a film deposition position as the substrate travels in the longitudinal direction from the feed roll to the take-up roll on a predetermined path including the film deposition position for depositing a film on the substrate, with the substrate fed from the feed roll in synchronism with the winding of the substrate having the film formed thereon on the take-up roll.

As is well known, according to plasma CVD (capacitively coupled plasma CVD), an electrode pair including a film deposition electrode and a counter electrode is formed so as to sandwich therebetween a substrate on which a film is to be formed, and film deposition gases are supplied between the electrodes of the pair while also supplying RF power to the film deposition electrode to generate plasma, thereby forming a film.

Such a plasma CVD process uses a grounded shield for efficient film deposition. The grounded shield is a grounded conductive prismatic member which is disposed so as to surround the film deposition electrode. The grounded shield prevents the generation of plasma in other areas than the area between the substrate and the film deposition electrode. The generated plasma is confined between the substrate and the film deposition electrode and can be effectively used for efficient film deposition.

As described in JP 2010-111900 A and JP 2010-121159 A, the grounded shield is also used in the roll-to-roll plasma CVD devices.

### SUMMARY OF THE INVENTION

It is known that, in the plasma CVD, the central portion and the peripheral end portion of the film deposition electrode (the center and the peripheral end of plasma) have generally different plasma properties.

According to the plasma CVD using a grounded shield, the density of plasma generated in the central portion of the film deposition electrode is substantially uniform but the plasma density is increased on the periphery of the film deposition electrode compared to the central portion.

Upon contact with a higher density plasma than necessary, the substrate suffers damage such as deformation due to heat or surface roughening due to the plasma.

In a common film deposition process of a so-called batch type, the film depositing position of the substrate does not change during the film deposition. Therefore, the film deposition can be performed with the substrate only in contact with proper plasma in the central portion by disposing the substrate in the central portion of the film deposition electrode.

In contrast, in the roll-to-roll plasma CVD, a long strip of substrate travels in its longitudinal direction. Therefore, high-density plasma cannot be prevented from coming into contact with the substrate and optionally the film formed, in the upstream and downstream end portions of the film deposition electrode in the conveying direction of the substrate.

Therefore, in the roll-to-roll plasma CVD, the high-density plasma causes damage to the substrate such as thermal deformation, change of properties or surface roughening of the substrate in the upstream and downstream end portions of the film deposition electrode, thus making it difficult to consistently manufacture proper products.

An object of the present invention is to overcome the prior art problems by providing a film deposition device in which film deposition is performed by plasma CVD as a substrate travels in its longitudinal direction, the device being capable of advantageously achieving the effect of effectively utilizing plasma in the presence of a grounded shield, preventing the substrate from contacting a high-density plasma in the vicinities of the end portions of the film deposition electrode and particularly in the upstream end portion of the film deposition electrode in the substrate conveying direction and also preventing the substrate from undergoing transformation, change of properties or surface roughening due to the high-density plasma, thus enabling proper products to be consistently manufactured.

In order to achieve the above object, the present invention provides a film deposition device comprising: a conveying unit for conveying a strip of substrate in a conveying direction; a film deposition electrode disposed so as to face the substrate; a counter electrode which is disposed on an opposite side of the film deposition electrode with respect to the substrate and which forms an electrode pair with the film deposition electrode; a gas supply unit for supplying film deposition gases between the film deposition electrode and the substrate; and a grounded shield disposed in a planar direction of the substrate so as to surround the film deposition electrode, wherein an upstream substrate-side end of the film deposition electrode in the conveying direction of the substrate is closer to the substrate than an upstream substrate-side end of the grounded shield in the conveying direction of the substrate which corresponds to the upstream substrate-side end of the film deposition electrode in the conveying direction of the substrate.

A downstream substrate-side end of the film deposition electrode in the conveying direction of the substrate is preferably closer to the substrate than a downstream substrate-side end of the grounded shield in the conveying direction of the substrate. The upstream and downstream substrate-side ends of the film deposition electrode extending in a width direction of the substrate are preferably closer to the substrate than the upstream and downstream substrate-side ends of the grounded shield in the width direction of the substrate.

A substrate-side end of the film deposition electrode in a portion where the film deposition electrode is preferably closer to the substrate than the grounded shield is closer to the substrate by 1 to 20 mm than its corresponding substrate-side end of the grounded shield. Except the portion where the substrate-side end of the film deposition electrode is closer to the substrate than its corresponding substrate-side end of the grounded shield, a first distance from the substrate-side end of the grounded shield to the substrate is preferably equal to or shorter than a second distance from the substrate-side end of the film deposition electrode to the substrate.

Corners of the film deposition electrode facing the substrate are preferably curved at a radius of curvature of at least 2 mm.

The film deposition device preferably further includes a second grounded shield which is disposed in the planar direction of the substrate so as to surround the grounded shield. A distance from substrate-side ends of the second grounded shield to the substrate is preferably equal to or shorter than a distance from the substrate-side ends of the film deposition electrode to the substrate in an entire area of the second grounded shield.

The film deposition electrode preferably has a gas supply space which is formed inside and gas supply holes which are formed in a surface of the film deposition electrode facing the substrate and which communicate with the gas supply space, and the gas supply unit preferably supplies the film deposition gases to the gas supply space.

The conveying unit preferably conveys the substrate by wrapping around a predetermined region of a peripheral surface of a cylindrical drum which serves as the counter electrode. A surface of the film deposition electrode facing the substrate is preferably curved so as to be parallel to the peripheral surface of the drum.

In the film deposition device of the invention having the foregoing configuration, when the substrate side is deemed to be above, at least on the upstream side of the film deposition electrode in the substrate conveying direction, the upstream upper end portion of the grounded shield is made at a lower position than the corresponding upstream upper end portion of the film deposition electrode.

Therefore, plasma in the vicinities of the end portions of the film deposition electrode can be discharged outside the grounded shield through the portion where the upper end portion of the grounded shield is at a lower position than the corresponding upper end portion of the film deposition electrode, thus preventing the substrate from contacting a high-density plasma in the end portions of the film deposition electrode.

Therefore, the present invention prevents the substrate from undergoing deformation or change of properties due to heat from a high-density plasma or surface roughening due to contact with the high-density plasma, thus enabling high-quality products having a film deposited on proper substrates to be consistently manufactured.

### BRIEF DESCRIPTION OF THE DRAWINGS

FIG. 1 is a conceptual view showing an embodiment of a film deposition device of the invention.
FIG. 2A is a plan view of a film deposition region of the film deposition device shown in FIG. 1.
FIG. 2B is a partially enlarged view of FIG. 1.
FIG. 2C is a conceptual view showing another example of a film deposition electrode which is applicable to the present invention.
FIGS. 3A to 3C are views conceptually showing another embodiment of the film deposition device of the present invention; FIG. 3A being a plan view of the film deposition region; FIG. 3B being a view of the film deposition region when seen from the substrate conveying direction; and FIG. 3C being a front view.
FIG. 4 is a conceptual plan view of the film deposition region in another embodiment of the film deposition device of the present invention.

### DETAILED DESCRIPTION OF THE INVENTION

Next, the film deposition device of the present invention is described in detail by referring to the preferred embodiments shown in the accompanying drawings.

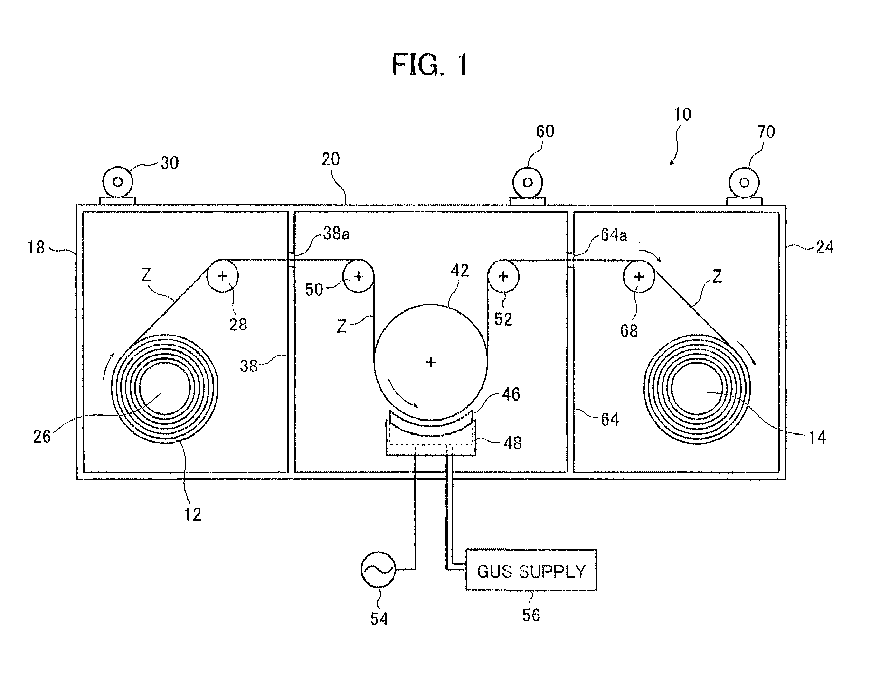

FIG. 1 is a conceptual view showing an embodiment of a film deposition device of the present invention.

A film deposition device 10 in the illustrated embodiment performs film formation on a surface of a long strip of substrate Z (a film material in the form of a web) by CCP (capacitively coupled plasma)-CVD as it travels in the longitudinal direction, thereby manufacturing functional films such as gas barrier films.

The deposition device 10 is a so-called "roll-to-roll" film deposition device in which the long strip of substrate Z is fed from a substrate roll 12 having the substrate Z wound into a roll and travels in its longitudinal direction while a film is formed on the substrate Z by CCP-CVD, and the substrate Z having the film formed thereon is rewound onto a take-up shaft 14.

In the film deposition device 10 of the present invention, the substrate (base) Z for use in film deposition is not particularly limited and various types of long sheets capable of film deposition by plasma CVD may be all used.

Specific examples of the substrate Z that may be advantageously used include plastic films (resin films) made of organic materials such as polyethylene terephthalate (PET), polyethylene naphthalate (PEN), polyethylene, polypropylene, polystyrene, polyamide, polyvinyl chloride, polycarbonate, polyacrylonitrile, polyimide, polyacrylate, and polymethacrylate.

The substrate Z to be used in the present invention may be a sheet material which has layers (films) for imparting various functions (e.g., a protective layer, an adhesive layer, a light-reflecting layer, a light-shielding layer, a planarizing layer, a buffer layer, and a stress-relief layer) formed on any of the plastic films serving as the support.

The substrate Z used may be a sheet material having a single layer formed on a support or a sheet material having a plurality of layers formed on a support. In the latter case, the layers formed may be of the same type.

As described above, the film deposition device 10 shown in FIG. 1 is the so-called roll-to-roll film deposition device in which the long strip of substrate Z is fed from the substrate roll 12 having the substrate Z wound into a roll and travels in its longitudinal direction while a film is formed on the substrate Z, and the substrate Z having the film formed thereon is rewound onto the take-up shaft 14. The film deposition device 10 includes a feed chamber 18, a film deposition chamber 20 and a take-up chamber 24.

In addition to the illustrated members, the film deposition device 10 may also have various members of a roll-to-roll film deposition device by means of plasma CVD including various sensors, and various members (conveyor means) for causing the substrate Z to travel along a predetermined path, as exemplified by a pair of conveyor rollers and a guide member for regulating the position in the width direction of the substrate Z.

The feed chamber 18 includes a rotary shaft 26, a guide roller 28 and a vacuum evacuation means 30.

The substrate roll 12 into which the long strip of substrate Z is wound is mounted on the rotary shaft 26 of the feed chamber 18.

Upon mounting of the substrate roll 12 on the rotary shaft 26, the substrate Z is caused to travel along a predetermined path starting from the feed chamber 18 and passing through the film deposition chamber 20 to reach the take-up shaft 14 of the take-up chamber 24.

In the film deposition device 10, feeding of the substrate Z from the substrate roll 12 and winding of the substrate Z on the take-up shaft 14 in the take-up chamber 24 are carried out in synchronism to perform continuous film deposition by CCP-CVD in the film deposition chamber 20 on the long strip of substrate Z traveling in its longitudinal direction along the predetermined path.

In the feed chamber 18, the rotary shaft 26 is rotated by a drive source (not shown) in a clockwise direction in FIG. 1 so that the substrate Z is fed from the substrate roll 12, guided by the guide roller 28 along the predetermined path and passes through a slit 38a provided in a partition wall 38 to reach the film deposition chamber 20.

In the preferred embodiment of the illustrated film deposition device 10, the feed chamber 18 and the take-up chamber 24 are provided with vacuum evacuation means 30 and 70, respectively. The vacuum evacuation means are provided in these chambers so that the pressures (degrees of vacuum) in these chambers may be the same as or slightly higher than that in the film deposition chamber 20 to be described below to thereby prevent the pressures in the neighboring chambers from adversely affecting the pressure in the film deposition chamber 20 (i.e., film deposition in the film deposition chamber 20).

The vacuum evacuation means 30 is not particularly limited, and exemplary means that may be used include vacuum pumps' such as a turbo pump, a mechanical booster pump, a dry pump, and a rotary pump, an assist means such as a cryogenic coil, and various other known (vacuum) evacuation means which use a means for adjusting the ultimate degree of vacuum or the amount of air discharged and are employed in vacuum deposition devices. In this regard, the same applies to other vacuum evacuation means 60 and 70 to be described later.

As described above, the substrate Z is guided by the guide roller 28 to reach the film deposition chamber 20 through the slit 38a of the partition wall 38.

The film deposition chamber 20 is provided to perform film deposition on the surface of the substrate Z by CCP-CVD. In the illustrated embodiment, the film deposition chamber 20 includes a drum 42, a film deposition electrode 46, a grounded shield 48, guide rollers 50 and 52, an RF power supply 54, a gas supply means 56, and the vacuum evacuation means 60.

The drum 42 in the film deposition chamber 20 is a cylindrical member rotating counterclockwise about the central axis in FIG. 1, and the substrate Z guided by the guide roller 50 along the predetermined path is passed over a predetermined region of the peripheral surface (at a predetermined angle) to travel in the longitudinal direction as it is held in predetermined positions facing the film deposition electrode 46 to be described later.

The drum 42 also serves as a counter electrode in CCP-CVD and forms a pair of electrodes with the film deposition electrode 46.

Therefore, the drum 42 may be connected to a bias power supply or grounded. Alternatively, the drum 42 may be capable of switching between connection to the bias power supply and grounding.

In the film deposition device 10, the drum 42 may have a temperature adjusting means for adjusting the temperature of the substrate Z during the film deposition.

The temperature adjusting means of the drum 42 is not particularly limited and various types of temperature adjusting means may be used including one containing a refrigerant or a heating agent circulating in the drum.

The film deposition electrode 46 is a known shower head electrode (shower head plate) which discharges film deposition gases from its surface facing the substrate Z and is used for film deposition by CCP-CVD.

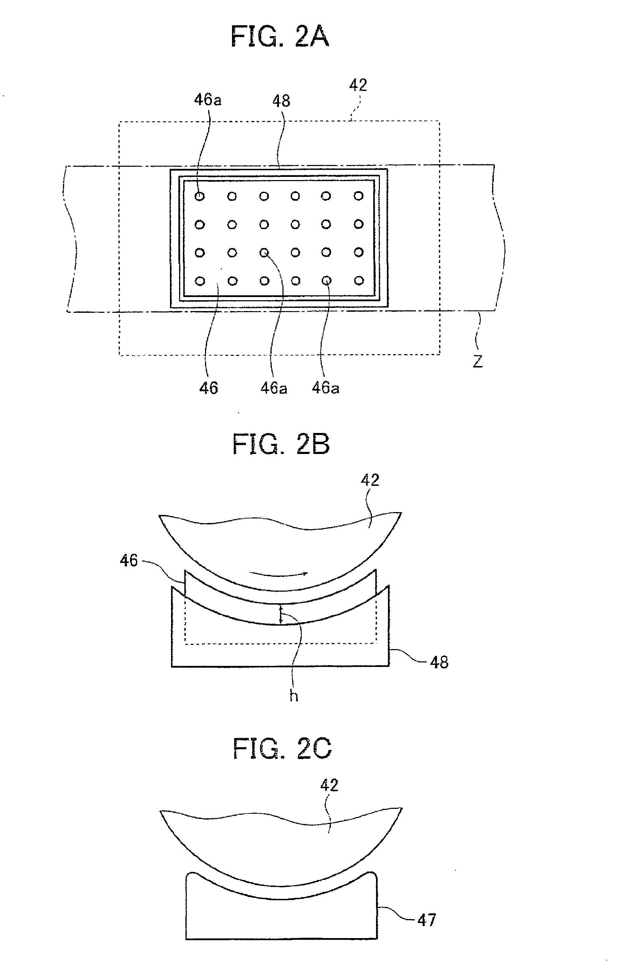

FIG. 2A is a conceptual plan view of the film deposition electrode 46 (film deposition region) (conceptual view seen from the substrate Z side); and FIG. 2B conceptually shows, in enlarged view, the vicinity of the film deposition electrode 46 seen from the same direction as in FIG. 1. In FIG. 2A, the substrate Z travels from left to right.

In the illustrated embodiment, the film deposition electrode 46 is, for example, in the form of a hollow, substantially rectangular solid and is disposed so that one surface faces the drum 42 (i.e., substrate Z).

In the illustrated embodiment, the surface of the film deposition electrode 46 facing the drum 42, that is, the upper surface in FIG. 1 has a downwardly curved or recessed, arc-like surface so as to be parallel to the outer peripheral surface of the drum 42 (i.e., so that the distance between the surface of the film deposition electrode 46 and the outer peripheral surface of the drum 42 is entirely the same). In other words, the film deposition electrode 46 has the recessed arc-like surface, a rectangular bottom surface, two rectangular lateral wall surfaces on the upstream and downstream sides in the conveying direction of the substrate Z, and two plate-like lateral wall surfaces on both sides in the width direction perpendicular to the conveying direction of the substrate Z, these lateral wall surfaces being downwardly curved on the drum side (i.e., on the upper side in FIG. 1).

As shown in FIG. 2A, a large number of gas supply holes 46a are formed in the surface of the film deposition electrode 46 facing the drum 42. The gas supply holes 46a communicate with the space within the film deposition electrode 46 (gas supply space). The gas supply means 56 to be described later supplies film deposition gases to the space within the film deposition electrode 46.

Therefore, the film deposition gases supplied from the gas supply means 56 are then supplied through the gas supply holes 46a of the film deposition electrode 46 to the space between the drum 42 (substrate Z) and the film deposition electrode 46.

The film deposition electrode 46 according to the present invention is not limited to the illustrated type having the curved plane and may be in the form of a hollow rectangular solid (a hollow plate) or may have a curved shape not parallel to the peripheral surface of the drum.

Thus, the present invention allows any of known shower head electrodes used in CCP-CVD.

The surface of the film deposition electrode facing the substrate Z (drum 42) preferably has curved corners (ends), as conceptually shown in a film deposition electrode 47 in FIG. 2C and the corners more preferably have a radius of curvature of at least 2 mm.

This facilitates the outward discharge of plasma from the corners of the film deposition electrodes 47 to prevent the plasma density from being increased at the end portions of the film deposition electrode 47, whereby the substrate Z can be more advantageously prevented from being deformed by the high-density plasma in combination with the effect obtained by disposing the grounded shield 48 to be described later so that its upper surface is at a lower position than its corresponding upper surface of the film deposition electrode.

In the illustrated embodiment, one film deposition electrode (film deposition means using CCP-CVD) is provided in the film deposition chamber 20. However, the present invention is not limited to this configuration and a plurality of film deposition electrodes may be disposed in the direction in which the substrate Z travels.

Further, the present invention is not limited to a configuration using the shower head electrode and a CCP-CVD device may be used which includes a film deposition electrode having no film deposition gas discharge holes (film deposition gas supply means), a counter electrode forming an electrode pair with the film deposition electrode, and nozzles for supplying film deposition gases between the film deposition electrode and the counter electrode.

The gas supply means 56 is a known gas supply means employed in vacuum film deposition devices such as plasma CVD devices.

As described above, the gas supply means 56 supplies film deposition gases to the space within the film deposition electrode 46. A large number of gas supply holes 46a are formed in the (curved) surface of the film deposition electrode 46 facing the drum 42. Therefore, the film deposition gases supplied into the film deposition electrode 46 pass through the gas supply holes 46a to be introduced into the space between the film deposition electrode 46 and the drum 42.

Each of the film deposition gases (process gas/ material gas) supplied from the gas supply means 56 may be of a known type suitable to the film to be formed on the surface of the substrate Z.

For example in the case of forming a silicon nitride film on the surface of the substrate Z, the gas supply means 56 may supply the film deposition gases such as a combination of silane gas, ammonia gas and hydrogen gas or a combination of silane gas, ammonia gas and nitrogen gas.

The RF power supply 54 supplies plasma excitation power to the film deposition electrode 46. Known RF power supplies used in various plasma CVD devices can be all used for the RF power supply 54 as exemplified by a power supply that supplies 13.56 MHz RF power.

The vacuum evacuation means 60 evacuates the film deposition chamber 20 to keep it at a predetermined film deposition pressure for plasma CVD film deposition, and is of a known type used in vacuum deposition devices as described above.

According to the present invention, the film deposition conditions such as the amounts of film deposition gases to be supplied and the magnitude of plasma excitation power are not specifically limited.

The film deposition conditions may be determined as appropriate according to the type and thickness of the film to be formed, required film deposition rate, kind of substrate Z, and the like as in a common plasma CVD film deposition process.

In the illustrated film deposition device 10, the film deposition chamber 20 is provided with the grounded shield 48.

The grounded shield 48 is a prismatic member (in the form of a substantially quadrangular prism in the illustrated embodiment) which is disposed in the planar direction of the substrate Z so as to surround the film deposition electrode 46. In other words, the grounded shield 48 includes a rectangular bottom surface which is larger than the bottom surface of the film deposition electrode 46, two rectangular lateral wall surfaces on the upstream and downstream sides in the conveying direction of the substrate Z, and two plate-like lateral wall surfaces on both sides in the width direction perpendicular to the conveying direction of the substrate Z, these lateral wall surfaces being downwardly curved on the drum side (i.e., on the upper side in FIG. 1). The surface formed with the ends of these four lateral wall surfaces on the side of the substrate Z (i.e., the upper ends in FIG. 1) is downwardly curved as in the film deposition electrode 46.

The grounded shield 48 is made of a conductive material as in known grounded shields for use in CCD-CVD and is usually grounded. As in the known grounded shields, the grounded shield 48 is formed and disposed so that the distance between the film deposition electrode 46 and the grounded shield 48 (distance in the planar direction of the substrate) is reduced to prevent discharge (generation of plasma) from occurring between the film deposition electrode 46 and the grounded shield 48.

In the illustrated embodiment, it is preferred for the grounded shield 48 also to have such a shape that the upper ends (ends on the side of the substrate Z or the drum 42) of the four lateral wall surfaces are parallel to the outer peripheral surface of the drum 42.

In other words, the upper ends of the lateral wall surfaces in the grounded shield 48 on the upstream and downstream sides in the substrate conveying direction (hereinafter referred to simply as "upstream side/downstream side") are linear portions extending in the width direction of the substrate Z or the drum 42 (direction perpendicular to the substrate conveying direction; hereinafter referred to simply as "width direction"), and the upper ends of the lateral wall surfaces on both the lateral sides perpendicular to the width direction of the substrate Z are arc-shaped or curved so as to be parallel to the outer peripheral surface of the drum 42.

In the film deposition device 10 of the present invention, at least the upper end of the lateral wall surface of the film deposition electrode 46 which extends in the width direction on the upstream side in the substrate conveying direction is closer or more adjacent to the substrate Z or the drum 42 than the upper end of the lateral wall surface of the grounded shield 48 extending in the width direction which corresponds to the upper end in the film deposition electrode 46. That is, in the illustrate embodiment, when the substrate Z side is deemed to be above, at least the upper end of the upstream lateral wall surface of the grounded shield 48 in the substrate conveying direction is at a lower position than the corresponding upper end of the upstream lateral wall surface of the film deposition electrode 46. In other words, assuming that the direction from the surface of the film deposition electrode 46 facing the substrate Z toward the substrate Z or drum 42 is the height direction, at least the upper end of the upstream lateral wall surface of the grounded shield 48 is at a lower position than the corresponding upper end of the upstream lateral wall surface of the film deposition electrode 46 with respect to the substrate Z located above.

In the illustrated embodiment, in the entire periphery surrounding the film deposition electrode 46, the upper ends of the lateral wall surfaces of the film deposition electrode 46 which constitute the circumference of the upper surface thereof are closer or more adjacent to the substrate Z or the drum 42 by a distance h than the corresponding upper ends of the lateral wall surfaces of the grounded shield 48 which constitute the circumference of the upper surface thereof. That is, in the illustrated embodiment, the upper ends of the lateral wall surfaces of the grounded shield 48 are at lower positions by a height h than the upper ends of the lateral wall surfaces of the film deposition electrode 46 on the entire periphery surrounding the film deposition electrode 46.

High-density plasma in the vicinities of the end portions of the film deposition electrode 46 may heat the substrate Z to cause deformation or discoloration or roughen the surface of the substrate Z, and these defects are eliminated by having such a configuration in the present invention.

As described above, the grounded shield provided so as to surround the film deposition electrode in plasma CVD prevents the generation of plasma in other regions than the region between the substrate and the film deposition electrode (film deposition region), and the generated plasma is confined between the substrate and the film deposition electrode and can be effectively used for efficient film deposition.

However, in plasma CVD using such a grounded shield, the plasma density is increased in the vicinities of the end portions of the film deposition electrode (plasma ends). A contact of the substrate with high-density plasma causes deformation or discoloration of the substrate due to heat or roughening of the substrate surface due to the plasma, whereby a proper product cannot be produced.

In the batch type film deposition in which the substrate is fixed, the substrate can be prevented from being exposed to high-density plasma by disposing the substrate in the central region of the film deposition electrode. However, in the roll-to-roll system in which a long strip of substrate travels in the longitudinal direction, the substrate cannot be prevented from coming in contact with high-density plasma at the end portions on the upstream and downstream sides of the film deposition electrode.

As also described in JP 2010-111900 A and JP 2010-121159 A, in plasma CVD using a grounded shield, the upper end surface of the grounded shield is usually at a position which is equal in height or higher than the upper end surface of the film deposition electrode, in other words, the upper end surface of the grounded shield is made flush with the upper end surface of the film deposition electrode or closer to the substrate than the upper end surface of the film deposition electrode, or the distance between the substrate and the upper end surface of the grounded shield is made equal to or smaller than the distance between the substrate and the upper end surface of the film deposition electrode in order to positively prevent plasma from being generated in unnecessary regions while improving the use efficiency of the generated plasma (i.e., confining the plasma in the film deposition region between the electrode and the substrate).

In contrast, in the film deposition device 10 of the present invention, at least the upper end of the upstream lateral wall surface of the film deposition electrode 46 extending in the width direction is made closer to the substrate Z (i.e., drum 42) than the upper end of the upstream lateral wall surface of the grounded shield 48 extending in the width direction. In other words, in the illustrated embodiment, at least the upper end of the upstream lateral wall surface of the grounded shield 48 is made at a lower position than the corresponding upper end of the upstream lateral wall surface of the film deposition electrode 46.

Such a configuration enables plasma from being discharged outside from the portion of the grounded shield 48 which is more distant from the substrate Z than the film deposition electrode 46 (i.e., from the portion where the upper end of the lateral wall surface of the grounded shield 48 is at a lower position than the corresponding upper end of the lateral wall surface of the film deposition electrode 46. As a result, the plasma density in the vicinities of the end portions of the film deposition electrode 46 can be reduced and the change of properties and the deformation of the substrate Z and surface roughening due to contact with the high-density plasma (hereinafter collectively referred to as "damage to the substrate Z") can be prevented from occurring.

In the film deposition device 10 of the present invention, the height h from the upper end portion of the grounded shield 48 to its corresponding upper end portion of the film deposition electrode 46 is not particularly limited and the beneficial effect can be achieved if the distance from the film deposition electrode 46 to the substrate Z is even slightly smaller than that from the grounded shield 48 to the substrate Z, that is, if the upper end portion of the grounded shield 48 is at a slightly lower position than the corresponding upper end portion of the film deposition electrode 46.

In the following description, according to the illustrated embodiment, the substrate-side end of the lateral wall surface of the film deposition electrode 46 or the grounded shield 48 is deemed to be higher when it is closer to the substrate Z or the drum 42, and to be lower when it is more distant from the substrate Z or the drum 42. The difference between the distance from the film deposition electrode 46 to the substrate Z and the distance from the grounded shield 48 to the substrate Z is referred to below as the height or difference.

However, the height h from the upper end portion of the grounded shield 48 to the corresponding upper end portion of the film deposition electrode 46 (i.e., the difference h between the distance from the upper end portion of the grounded shield 48 to the drum 42 and that from the upper end portion of the film deposition electrode 46 to the drum 42) is preferably at least 1 mm in order to sufficiently suppress the deformation or surface roughening of the substrate Z due to the high-density plasma.

The amount of plasma discharged outside the grounded shield 48 is increased with increasing height h. In other words, the inherent action of the grounded shield 48 is reduced, resulting in a decrease in the use efficiency of the plasma in the film deposition. In consideration of this point, the height h is preferably up to 20 mm.

The height h from the upper end portion of the grounded shield 48 to the corresponding upper end portion of the film deposition electrode 46 is most preferably from 5 to 10 mm because the foregoing effects can be advantageously obtained.

In the embodiment shown in FIG. 1 and FIGS. 2A to 2C, the upper surface of the grounded shield 48 is at a lower position than the upper surface of the film deposition electrode 46 on the entire periphery of the film deposition electrode 46, i.e., on both of the upstream and downstream sides and on both the lateral sides perpendicular to the width direction.

However, this is not the sole case of the present invention but at least the upstream upper end portion of the grounded shield 48 should be at a lower position than the corresponding upstream upper end portion of the film deposition electrode 46. In other words, at the upstream end portion of the film deposition electrode 46, the surface of the substrate Z always comes in contact with plasma. Therefore, high-density plasma present in the region containing the upstream end portion causes damage to the substrate Z and therefore the upstream upper end portion of the grounded shield 48 should be only made at a lower position than the corresponding upper end portion of the film deposition electrode 46.

In contrast, high-density plasma present on both the lateral sides perpendicular to the width direction and on the downstream side does not always cause damage to the substrate Z. Therefore, in such a case, as in common devices, the grounded shield 48 may be disposed so that the lateral upper end portions perpendicular to the width direction and the downstream upper end portion are at positions which are equal in height or higher than the corresponding upper end portions of the film deposition electrode 46. In other words, the grounded shield 48 may be made closer to the substrate Z than the film deposition electrode 46.

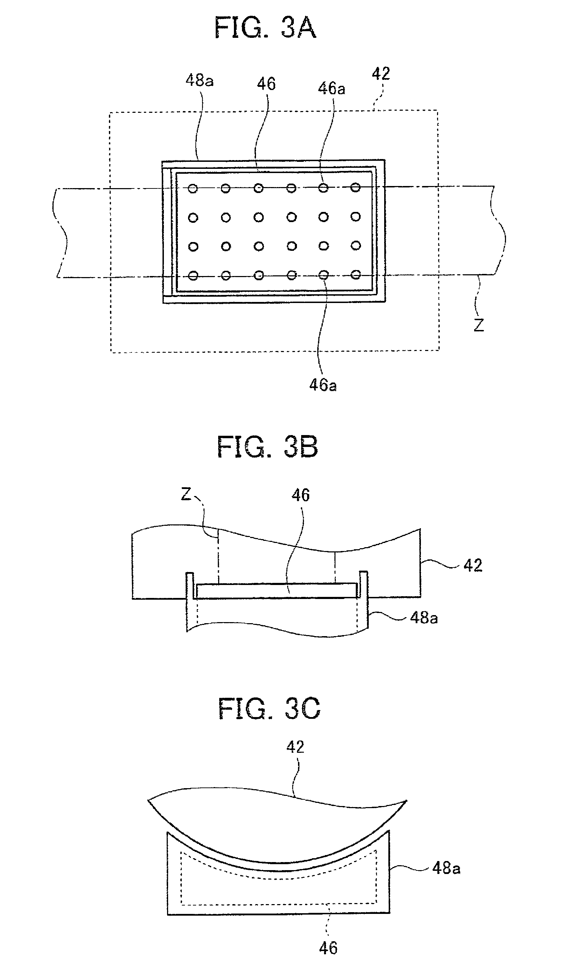

Another embodiment is conceptually shown in FIGS. 3A to 3C.
FIG. 3A is a plan view of the film deposition electrode 46; FIG. 3B shows the film deposition electrode 46 seen from the conveying direction of the substrate Z (i.e., from the upstream side toward the downstream side); and FIG. 3C is a front view seen from the same direction as FIG. 1. In FIG. 3A, the substrate Z also travels from left to right as in FIG. 2A.

For example in the case conceptually shown in FIG. 3A in which the substrate Z has a narrow width and both the lateral end portions of the substrate Z perpendicular to the width direction are located inside both the lateral end portions of the film deposition electrode 46 perpendicular to the width direction, even if the plasma on both the lateral end portions of the film deposition electrode 46 perpendicular to the width direction has a high density, the substrate Z does not contact the high-density plasma on both the lateral end portions of the film deposition electrode 46 perpendicular to its width direction.

Therefore, in such a case, as in a grounded shield 48a conceptually shown in FIGS. 3B and 3C, the grounded shield 48 may be disposed so that the upper end of its upstream lateral wall surface and optionally the upper end of its downstream lateral wall surface are only at lower positions than the upper end of the upstream lateral wall surface and optionally the downstream lateral wall surface of the film deposition electrode 46, and the upper ends of the lateral wall surfaces on both sides in the width direction of the grounded shield 48 are at positions which are equal in height or higher than the upper ends of the corresponding lateral wall surfaces on both sides in the width direction of the film deposition electrode 46.

In order to improve the film deposition efficiency by making use of the film deposition region, that is, plasma, between the film deposition electrode 46 and the substrate Z (drum 42), the grounded shield 48 may be disposed so that the upper ends of both the lateral wall surfaces perpendicular to the width direction and optionally the upper end of the downstream lateral wall surface are at higher positions than the upper ends of the corresponding lateral wall surfaces of the film deposition electrode 46, thereby preventing plasma in the film deposition region from being discharged from the lateral end portions of the grounded shield 48 perpendicular to the width direction. For example, both the lateral wall surfaces of the grounded shield 48 perpendicular to its width direction may be extended upward so as to have a height reaching just before or just below the peripheral surface of the drum 42.

In contrast, in the case shown in FIGS. 2A-2C in which the substrate Z has a larger size in the width direction than the film deposition electrode 46 and its lateral end portions are located on both the lateral end portions of the film deposition electrode 46 perpendicular to the width direction, if a high-density plasma is present on both the lateral end portions of the film deposition electrode 46 perpendicular to the width direction, the high-density plasma may cause damage to the substrate Z.

Therefore, in such a case, as in the grounded shield 48 shown in FIG. 1 and FIGS. 2A-2C, it is preferred for both the lateral wall surfaces of the grounded shield 48 perpendicular to the width direction to be also at lower positions than the corresponding lateral wall surfaces of the film deposition electrode 46 perpendicular to the width direction.

In many cases, film deposition is already performed on the downstream side of the film deposition electrode 46 and therefore the substrate Z is not directly exposed to plasma. In the case of forming an inorganic film (film made of an inorganic compound), the film may very often have an enough strength with respect to a high-density plasma.

Therefore, in cases where an inorganic film with a sufficiently large thickness is formed at the downstream end portion of the film deposition electrode 46 and there is no possibility that plasma causes damage to the substrate Z and optionally the film formed, the downstream upper end portion of the grounded shield 48 may also be at a position which is equal in height to the downstream upper end portion of the film deposition electrode 46.

Alternatively, in consideration of the film deposition efficiency improved by the plasma confinement, the upper end of the downstream lateral wall surface of the grounded shield 48 may be at a higher position than the upper end of the downstream lateral wall surface of the film deposition electrode 46. For example, the grounded shield 48 may have a height reaching just before the peripheral surface of the drum 42.

In other words, in the film deposition device of the present invention, the following four types of grounded shields can be used: one in which the upstream upper end portion is only at a lower position than the corresponding upstream upper end portion of the film deposition electrode 46 with respect to the substrate Z located above (assuming that the direction from the film deposition electrode 46 toward the substrate Z (drum 42) is the height direction); one in which the upstream and downstream upper end portions are at lower positions than the corresponding upstream and downstream upper end portions of the film deposition electrode 46 with respect to the substrate Z; one in which the upstream upper end portion and the lateral upper end portions perpendicular to the width direction are at lower directions than the corresponding upstream upper end portion and lateral upper end portions perpendicular to the width direction of the film deposition electrode 46 with respect to the substrate Z; and one in which the upper end portions of the entire periphery including the upstream and downstream upper end portions and the lateral upper end portions perpendicular to the width direction are at lower directions than the corresponding upper end portions of the film deposition electrode 46 with respect to the substrate Z.

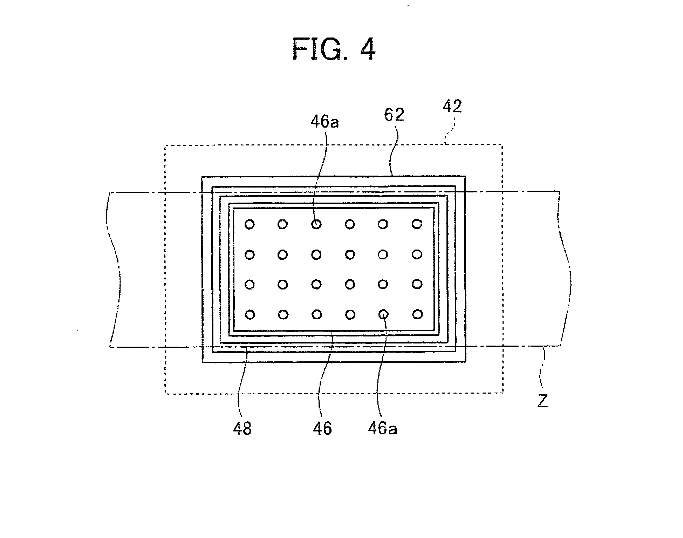

In the film deposition device 10 of the present invention, the grounded shield 48 may be surrounded by a second grounded shield 62 as schematically shown in FIG. 4.

The second grounded shield 62 enables the discharge of plasma from between the film deposition electrode 46 and the substrate Z (drum) 42 to be advantageously suppressed to improve the use efficiency of the generated plasma, thus leading to further efficient film deposition.

In order to improve the plasma confinement effect, the upper surface of the second grounded shield 62 is preferably at a position which is equal in height or higher than the upper surface of the film deposition electrode 46 as in common grounded shields.

As described above, the substrate Z guided by the guide roller 50 along the predetermined path is passed over the peripheral surface of the drum 42 and held in predetermined positions as it travels in the longitudinal direction. When the film deposition electrode 46 is supplied with plasma excitation power, a plasma is excited between the drum 42 and the film deposition electrode 46 forming an electrode pair, whereupon the film deposition gases form radicals to perform CCP-CVD film deposition on the surface of the substrate Z which is traveling on the drum 42 as it is supported thereby.

The substrate Z having a predetermined film deposited on a surface thereof is then guided by the guide roller 52 and travels through a slit 64a of a partition wall 64 to enter the take up chamber 24.

In the illustrated embodiment, the take-up chamber 24 includes a guide roller 68, the take-up shaft 14, and the vacuum evacuation means 70.

The substrate Z having reached the take-up chamber 24 travels to the take-up shaft 14 as it is guided by the guide roller 68 and is wound on the take-up shaft 14 to form a roll, which is then supplied to the subsequent step as a roll of gas barrier film.

The take-up chamber 24 is also provided with the vacuum evacuation means 70 as in the above-described feed chamber 18 and during film deposition, its pressure is reduced to a degree of vacuum suitable for the film deposition pressure in the film deposition chamber 20.

The operation of the film deposition device 10 is described below.

Upon mounting of the substrate roll 12 on the rotary shaft 26, the substrate Z is let out from the substrate roll 12 and travels along the predetermined path along which the substrate Z is guided by the guide roller 28 in the feed chamber 18 to reach the film deposition chamber 20, where the substrate Z is guided by the guide roller 50, passed over a predetermined region of the peripheral surface of the drum 42 and guided by the guide roller 52 to reach the take-up chamber 24, where the substrate Z is guided by the guide roller 68 to reach the take-up shaft 14.

Subsequently, the vacuum evacuation means 30, 60, and 70 are actuated to evacuate the chambers to predetermined pressures. When the degrees of vacuum in the chambers stabilize, the gas supply means 56 in the film deposition chamber 20 supplies the film deposition electrode 46 with the film deposition gases.

When the film deposition chamber 20 stabilizes at a predetermined pressure suitable to the film deposition, the traveling of the substrate Z from the feed chamber 18 to the take-up chamber 24 is started and supply of the plasma excitation power from the RF power supply 54 to the film deposition electrode 46 is also started.

The substrate Z having reached the film deposition chamber 20 from the feed chamber 18 is guided by the guide roller 50 and further travels as it is passed over the drum 42 and an intended layer is formed by CCP-CVD in the region where the drum 42 and the film deposition electrode 46 face each other.

In the film deposition chamber 20, the grounded shield 48 is provided so as to surround the film deposition electrode 46 and therefore plasma can be advantageously confined in the region where the drum 42 and the film deposition electrode 46 face each other to perform efficient film deposition with high plasma use efficiency.

In the film deposition device 10, at least the upstream upper end portion of the grounded shield 48 is at a lower position than the corresponding upstream upper end portion of the film deposition electrode 46. Therefore, the plasma density can be prevented from increasing in the upstream end portion of the film deposition electrode 46 to suppress the damage to the substrate Z due to the high-density plasma, whereby high-quality products can be consistently manufactured.

The substrate Z having a predetermined film deposited thereon is then guided by the guide roller 52 and travels to enter the take up chamber 24.

The substrate Z having reached the take-up chamber 24 is guided by the guide roller 68 along the predetermined path and rewound by the take-up shaft 14 into a roll, which is then supplied to the subsequent step.

While the film deposition device of the present invention has been described above in detail, the present invention is by no means limited to the foregoing embodiment and it should be understood that various improvements and modifications are possible without departing from the scope of the present invention.

For example, the embodiment shown in FIG. 1 shows the device in which film deposition is performed on the substrate Z which is passed over the peripheral surface of the cylindrical drum as it travels in the longitudinal direction. However, this is not the sole case of the invention. For example, the film deposition device of the present invention may also be advantageously applied to a device which performs film deposition as the substrate Z travels linearly (on the plane) as described in JP 2010-111900 A. In other words, the present invention may be applied to all of film deposition devices of various configurations as long as film deposition is performed by plasma CVD as a long strip of substrate travels in the longitudinal direction.

### EXAMPLES

### [Example 1]

The film deposition device 10 shown in FIG. 1 was used to deposit a silicon nitride film on a substrate Z.

The substrate Z used was a PET film with a thickness of 100 µm. The surface roughness Ra of the substrate Z as measured by an atomic force microscope (AFM) was 0.7 nm.

The grounded shield 48 used was made of aluminum. The shield 48 was grounded at a distance of 1 mm from the film deposition electrode 46.

As shown in FIGS. 1 and 2A to 2C, the grounded shield 48 was disposed so that the upstream and downstream upper end portions and both the lateral upper end portions perpendicular to the width direction (i.e., the entire upper surface of the grounded shield 48 surrounding the film deposition electrode 46) were at lower positions by 5 mm than the corresponding upper end portions of the film deposition electrode 46. That is, the height h (Δh) from the upper end portion of the grounded shield 48 to the upper end portion of the film deposition electrode 46 was set to 5 nm over the whole area.

The film deposition gases used were silane gas (SiH₄), ammonia gas (NH₃), nitrogen gas (N₂) and hydrogen gas (H₂). Silane gas, ammonia gas, nitrogen gas and hydrogen gas were supplied in amounts of 100 sccm, 200 sccm, 500 sccm, and 500 sccm, respectively.

The film deposition electrode 46 was supplied with 2000 W plasma excitation power at a frequency of 13.5 MHz.

The film deposition pressure was set to 30 Pa.

A silicon nitride film with a thickness of 50 nm was formed on the substrate Z under the film deposition conditions. The film deposition rate was 460 nm/min. The thickness of the silicon nitride film was measured by a stylus profilometer and adjusted by controlling the travel speed of the substrate Z.

After the film deposition, the silicon nitride film formed was peeled off and the surface roughness Ra of the substrate Z after the film deposition was measured by AFM in the same manner as the surface of the substrate Z. As a result, the substrate Z after the film deposition had a surface roughness Ra of 1.7 nm.

### [Example 2]

Example 1 was repeated except that the height h from the upper surface of the grounded shield 48 to that of the film deposition electrode 46 was changed to 10 mm and the travel speed of the substrate Z was changed to achieve a desired film thickness, thereby forming a silicon nitride film with a thickness of 50 nm on the surface of the substrate Z.

The film deposition rate was 400 nm/min. The surface roughness Ra of the substrate Z as measured after the film deposition in the same manner as Example 1 was 1.4 nm.

### [Example 3]

Example 1 was repeated except that the height h from the upper surface of the grounded shield 48 to that of the film deposition electrode 46 was changed to 15 mm and the travel speed of the substrate Z was changed to achieve a desired film thickness, thereby forming a silicon nitride film with a thickness of 50 nm on the surface of the substrate Z.

The film deposition rate was 290 nm/min. The surface roughness Ra of the substrate Z as measured after the film deposition in the same manner as Example 1 was 1.3 nm.

### [Comparative Example 1]

Example 1 was repeated except that the height h from the upper surface of the grounded shield 48 to that of the film deposition electrode 46 was changed to 0 mm (i.e., the upper surface of the grounded shield 48 was made flush with the upper surface of the film deposition electrode 46) and the travel speed of the substrate Z was changed to achieve a desired film thickness, thereby forming a silicon nitride layer with a thickness of 50 nm on the surface of the substrate Z.

The film deposition rate was 500 nm/min. The surface roughness Ra of the substrate Z as measured after the film deposition in the same manner as Example 1 was 3.1 nm.

### [Example 4]

Example 1 was repeated except that corners of the region of the film deposition electrode 46 facing the drum 42 were curved at a radius of curvature of 5 mm and the travel speed of the substrate Z was changed to achieve a desired film thickness, thereby forming a silicon nitride film with a thickness of 50 nm on the surface of the substrate Z.

The film deposition rate was 440 nm/min. The surface roughness Ra of the substrate Z as measured after the film deposition in the same manner as Example 1 was 1.5 nm.

### [Example 5]

Example 1 was repeated except that the upstream upper end portion of the grounded shield 48 was only made at a lower position by 5 mm than the upstream upper end portion of the film deposition electrode 46 and the other upper end portions of the grounded shield 48 were made flush with the corresponding upper end portions of the film deposition electrode 46, and the travel speed of the substrate Z was changed to achieve a desired film thickness, thereby forming a silicon nitride film with a thickness of 50 nm on the surface of the substrate Z.

The film deposition rate was 480 nm/min. The surface roughness Ra of the substrate Z as measured after the film deposition in the same manner as Example 1 was 1.9 nm.

### [Example 6]

Example 1 was repeated except that the second grounded shield 62 was provided outside the grounded shield 48 at a distance of 1 mm therefrom and the travel speed of the substrate Z was changed to achieve a desired film thickness, thereby forming a silicon nitride film with a thickness of 50 nm on the surface of the substrate Z.

The film deposition rate was 440 nm/min. The surface roughness Ra of the substrate Z as measured after the film deposition in the same manner as Example 1 was 1.5 nm.

### [Example 7]

Example 1 was repeated except that the height h from the upper surface of the grounded shield 48 to that of the film deposition electrode 46 was changed to 1 mm and the travel speed of the substrate Z was changed to achieve a desired film thickness, thereby forming a silicon nitride film with a thickness of 50 nm on the surface of the substrate Z.

The film deposition rate was 490 nm/min. The surface roughness Ra of the substrate Z as measured after the film deposition in the same manner as Example 1 was 2.2 nm.

### [Example 8]

Example 5 was repeated except that a silicon nitride film was deposited to a thickness of 10 nm and the travel speed of the substrate Z was changed to achieve a desired film thickness, thereby forming the silicon nitride film on the surface of the substrate Z.

The film deposition rate was 480 nm/min. The surface roughness Ra of the substrate Z as measured after the film deposition in the same manner as Example 1 was 2.1 nm.

### [Example 9]

Example 1 was repeated except that the height of the grounded shield 48 was only increased on the downstream side so that the distance between the grounded shield 48 and the drum 42 was 5 mm and the travel speed of the substrate Z was changed to achieve a desired film thickness, thereby forming a silicon nitride film with a thickness of 50 nm on the surface of the substrate Z. In the foregoing Examples and Comparative Examples, the distance between the film deposition electrode 46 and the drum 42 was 20 mm over the whole area.

The film deposition rate was 490 nm/min. The surface roughness Ra of the substrate Z as measured after the film deposition in the same manner as Example 1 was 1.6 nm.

The results are shown in Table 1 below.

**Table 1**

| | **Δh** | **Surface roughness** | **Film deposition rate** | **Remark** |
|---|---|---|---|---|
| **Example 1** | **5** | **1. 7** | **460** | |
| **Example 2** | **10** | **1.4** | **400** | |
| **Example 3** | **15** | **1. 3** | **290** | |
| **Comparative Example 1** | **0** | **3. 1** | **500** | |
| **Examples 4** | **5** | **1. 5** | **440** | **Electrode corners were curved.** |
| **Example 5** | **5** | **1. 9** | **480** | **Δh = 5 only upstream side; Δh = 0 in the other portions.** |
| **Example 6** | **10** | **1. 5** | **440** | **A second grounded shield was disposed.** |
| **Example 7** | **1** | **2. 2** | **490** | |
| **Example 8** | **5** | **2. 1** | **480** | **The film thickness was 10 nm; Δh = 5 only upstream side; Δh = 0 in the other portions.** |
| **Example 9** | **5** | **1.6** | **490** | **Δh = 5 only upstream side; the distance from the drum on the downstream side was 5 mm.** |

| | | | | |
|---|---|---|---|---|
| **The untreated substrate had a surface roughness of 0.7** | | | | |

As is seen from above, the larger the height (Δh) from the upper surface of the grounded shield 48 to that of the film deposition electrode 46 is, the more the damage to the surface of the substrate Z due to plasma is reduced. On the other hand, the film deposition rate is reduced. As shown in Comparative Example 1 and Example 7, the height from the upper surface of the grounded shield 48 to that of the film deposition electrode 46 of 1 mm is enough to achieve the effect of protecting the surface of the substrate Z from a high-density plasma. Therefore, as is clear from Examples 1 to 3 and 7, the height h from the upper surface of the grounded shield 48 to that of the film deposition electrode 46 may be set as appropriate for the required state of the substrate surface and film deposition rate, and a good balance can be struck between the protection of the substrate and the film deposition rate in a height range of 1 to 20 mm.

As shown in Example 4, the corners of the film deposition electrode 46 are curved to facilitate the discharge of plasma from the end portions of the electrode, and as a result the surface roughness of the substrate Z can be reduced. In addition, as shown in Examples 5 and 9, the effect of reducing the surface roughness of the substrate Z can be advantageously achieved even in the case where the upper surface of the grounded shield 48 is made at a lower position than that of the film deposition electrode 46 only on the upstream side on which the substrate Z comes in direct contact with plasma.

By providing the second grounded shield 62 outside the grounded shield 48 as shown in Example 6, plasma can be more advantageously prevented from spreading out to thereby ensure a comparatively high rate while reducing the surface roughness of the substrate Z.

In cases where the film formed on the substrate Z does not have a sufficient thickness as shown in Examples 8 and 9, it is preferred to dispose the grounded shield 48 so that its downstream upper end portion is also at a lower position than the corresponding downstream upper end portion of the film deposition electrode 46 in order to fully reduce the surface roughness of the substrate Z. However, as long as the film formed on the substrate Z has a sufficient thickness, adverse effects on the substrate Z can be reduced even if the downstream side of the film deposition electrode is exposed to a high-density plasma.

The above results clearly show the beneficial effects of the present invention.

The present invention can be advantageously used to manufacture various functional films such as gas barrier films and antireflective films.

## Claims

1. A film deposition device comprising:
conveying means for conveying a strip of substrate in a conveying direction;
a film deposition electrode disposed so as to face said substrate;
a counter electrode which is disposed on an opposite side of said film deposition electrode with respect to said substrate and which forms an electrode pair with said film deposition electrode;
gas supply means for supplying film deposition gases between said film deposition electrode and said substrate; and
a grounded shield disposed in a planar direction of said substrate so as to surround said film deposition electrode,
wherein an upstream substrate-side end of said film deposition electrode in the conveying direction of said substrate is closer to said substrate than an upstream substrate-side end of said grounded shield in the conveying direction of said substrate which corresponds to said upstream substrate-side end of said film deposition electrode in the conveying direction of said substrate.

2. The film deposition device according to claim 1, wherein a downstream substrate-side end of said film deposition electrode in the conveying direction of said substrate is closer to said substrate than a downstream substrate-side end of said grounded shield in the conveying direction of said substrate.

3. The film deposition device according to claim 1 or 2, wherein the upstream and downstream substrate-side ends of said film deposition electrode extending in a width direction of the substrate are closer to said substrate than the upstream and downstream substrate-side ends of said grounded shield in the width direction of the substrate.

4. The film deposition device according to any one of claims 1 to 3, wherein a substrate-side end of said film deposition electrode in a portion where said film deposition electrode is closer to said substrate than said grounded shield is closer to said substrate by 1 to 20 mm than its corresponding substrate-side end of said grounded shield.

5. The film deposition device according to any one of claims 1 to 4, wherein except the portion where the substrate-side end of said film deposition electrode is closer to said substrate than its corresponding substrate-side end of said grounded shield, a first distance from the substrate-side end of said grounded shield to said substrate is equal to or shorter than a second distance from the substrate-side end of said film deposition electrode to said substrate.

6. The film deposition device according to any one of claims 1 to 5, wherein corners of said film deposition electrode facing said substrate are curved at a radius of curvature of at least 2 mm.

7. The film deposition device according to any one of claims 1 to 6, further comprising a second grounded shield which is disposed in the planar direction of said substrate so as to surround said grounded shield.

8. The film deposition device according to claim 7, wherein a distance from substrate-side ends of said second grounded shield to said substrate is equal to or shorter than a distance from the substrate-side ends of said film deposition electrode to said substrate in an entire area of said second grounded shield.

9. The film deposition device according to any one of claims 1 to 8,
wherein said film deposition electrode has a gas supply space which is formed inside and gas supply holes which are formed in a surface of said film deposition electrode facing said substrate and which communicate with said gas supply space, and
wherein said gas supply means supplies said film deposition gases to said gas supply space.

10. The film deposition device according to any one of claims 1 to 9, wherein said conveying means conveys said substrate by wrapping around a predetermined region of a peripheral surface of a cylindrical drum which serves as said counter electrode.

11. The film deposition device according to claim 10, wherein a surface of said film deposition electrode facing said substrate is curved so as to be parallel to said peripheral surface of said drum.

## Patentansprüche

1. Filmabscheidungsvorrichtung, umfassend:
Beförderungsmittel zum Befördern eines Streifen eines Substrats in eine Beförderungsrichtung;
eine Filmabscheidungselektrode, die so angeordnet ist, dass sie dem Substrat zugewandt ist;
eine Gegenelektrode, die bezüglich des Substrats auf einer gegenüberliegenden Seite der Filmabscheidungselektrode angeordnet ist und die mit der Filmabscheidungselektrode ein Elektrodenpaar bildet;
Gaszuführmittel zum Zuführen von Filmabscheidungsgasen zwischen der Filmabscheidungselektrode und dem Substrat; und
eine geerdete Abschirmung, die in planarer Richtung des Substrats angeordnet ist, so dass sie die Filmabscheidungselektrode umgibt,
worin das in Beförderungsrichtung des Substrats zulaufseitige substratseitige Ende der Filmabscheidungselektrode näher ist am Substrat als das in Beförderungsrichtung des Substrats zulaufseitige substratseitige Ende der geerdeten Abschirmung, welche dem in Beförderungsrichtung des Substrats zulaufseitigen substratseitigen Ende der Filmabscheidungselektrode entspricht.

2. Filmabscheidungsvorrichtung gemäß Anspruch 1, worin das in Beförderungsrichtung des Substrats ablaufseitige substratseitige Ende der Filmabscheidungselektrode näher ist am Substrat als das in Beförderungsrichtung des Substrats ablaufseitige substratseitige Ende der geerdeten Abschirmung.

3. Filmabscheidungsvorrichtung gemäß Anspruch 1 oder 2, worin die zulaufseitigen und ablaufseitigen substratseitigen Enden der Filmabscheidungselektrode, die sich in der Breitenrichtung des Substrats ausdehnen, näher sind am Substrat als die zulaufseitigen und ablaufseitigen substratseitigen Enden der geerdeten Abschirmung in Breitenrichtung des Substrats.

4. Filmabscheidungsvorrichtung gemäß irgendeinem der Ansprüche 1 bis 3, worin das substratseitige Ende der Filmabscheidungselektrode in einem Bereich, worin die Filmabscheidungselektrode näher ist am Substrat als die geerdete Abschirmung, um 1 bis 20 mm näher ist am Substrat als das entsprechende substratseitige Ende der geerdeten Abschirmung.

5. Filmabscheidungsvorrichtung gemäß irgendeinem der Ansprüche 1 bis 4, worin, außer in dem Bereich, worin das substratseitige Ende der Filmabscheidungselektrode näher ist am Substrat als das entsprechende substratseitige Ende der geerdeten Abschirmung, ein erster Abstand von dem substratseitigen Ende der geerdeten Abschirmung zu dem Substrat gleich ist oder kürzer ist als ein zweiter Abstand von dem substratseitigen Ende der Filmabscheidungselektrode zum Substrat.

6. Filmabscheidungsvorrichtung gemäß irgendeinem der Ansprüche 1 bis 5, worin die Ecken der Filmabscheidungselektrode, die dem Substrat zugewandt sind, mit einem Kurvenradius von mindestens 2 mm gekrümmt sind.

7. Filmabscheidungsvorrichtung gemäß irgendeinem der Ansprüche 1 bis 6, ferner umfassend eine zweite geerdete Abschirmung, die in planarer Richtung des Substrats so angeordnet ist, dass sie die geerdete Abschirmung umgibt.

8. Filmabscheidungsvorrichtung gemäß Anspruch 7, worin in der gesamten Fläche der zweiten geerdeten Abschirmung ein Abstand von den substratseitigen Enden der zweiten geerdeten Abschirmung zu dem Substrat gleich ist oder kürzer ist als ein Abstand von den substratseitigen Enden der Filmabscheidungselektrode zu dem Substrat.

9. Filmabscheidungsvorrichtung gemäß irgendeinem der Ansprüche 1 bis 8, worin die Filmabscheidungselektrode einen Gaszuführraum, der innerhalb gebildet ist, und Gaszuführlöcher, die in einer Oberfläche der Filmabscheidungselektrode dem Substrat zugewandt gebildet sind und die kommunizierend mit dem Gaszuführraum ausgebildet sind, aufweist, und
worin das Gaszuführmittel die Filmabscheidungsgase zu dem Gaszuführraum zuführt.

10. Filmabscheidungsvorrichtung gemäß irgendeinem der Ansprüche 1 bis 9, worin das Beförderungsmittel das Substrat durch Umwickeln um einen vorbestimmten Bereich einer Umfangsoberfläche einer zylindrischen Trommel befördert, die als Gegenelektrode dient.

11. Filmabscheidungsvorrichtung gemäß Anspruch 10, worin eine Oberfläche der Filmabscheidungselektrode, die dem Substrat zugewandt ist, so gekrümmt ist, dass sie zur Umfangsoberfläche der Trommel parallel ist.

## Revendications

1. Dispositif de dépôt de film comprenant :
des moyens de transport pour transporter une bande de substrat dans une direction de transport ;
une électrode de dépôt de film disposée de manière à faire face au dit substrat ;
une contre-électrode qui est disposée d'un côté opposé à ladite électrode de dépôt de film par rapport au dit substrat et qui forme une paire d'électrodes avec ladite électrode de dépôt de film ;
des moyens d'alimentation en gaz pour fournir des gaz de dépôt de film entre ladite électrode de dépôt de film et ledit substrat ; et
un blindage mis à la masse disposé dans une direction plane dudit substrat de manière à entourer ladite électrode de dépôt de film,
dans lequel une extrémité côté substrat en amont de ladite électrode de dépôt de film dans la direction de transport dudit substrat est plus près dudit substrat qu'une extrémité côté substrat en amont dudit blindage mis à la masse dans la direction de transport dudit substrat qui correspond à ladite extrémité côté substrat en amont de ladite électrode de dépôt de film dans la direction de transport dudit substrat.

2. Dispositif de dépôt de film selon la revendication 1, dans lequel une extrémité côté substrat en aval de ladite électrode de dépôt de film dans la direction de transport dudit substrat est plus près dudit substrat qu'une extrémité côté substrat en aval dudit blindage mis à la masse dans la direction de transport dudit substrat.

3. Dispositif de dépôt de film selon la revendication 1 ou 2, dans lequel les extrémités côtés substrat en amont et en aval de ladite électrode de dépôt de film s'étendant dans une direction de largeur du substrat sont plus près dudit substrat que les extrémités côtés substrat en amont et en aval dudit blindage mis à la masse dans la direction de largeur du substrat.

4. Dispositif de dépôt de film selon l'une quelconque des revendications 1 à 3, dans lequel une extrémité côté substrat de ladite électrode de dépôt de film dans une partie dans laquelle ladite électrode de dépôt de film est plus près dudit substrat que ledit blindage mis à la masse est plus près dudit substrat de 1 à 20 mm que son extrémité côté substrat correspondante dudit blindage mis à la masse.

5. Dispositif de dépôt de film selon l'une quelconque des revendications 1 à 4, dans lequel, à l'exception de la partie dans laquelle l'extrémité côté substrat de ladite électrode de dépôt de film est plus près dudit substrat que son extrémité côté substrat correspondante dudit blindage mis à la masse, une première distance de l'extrémité côté substrat dudit blindage mis à la masse au dit substrat est égale ou inférieure à une deuxième distance de l'extrémité côté substrat de ladite électrode de dépôt de film au dit substrat.

6. Dispositif de dépôt de film selon l'une quelconque des revendications 1 à 5, dans lequel les coins de ladite électrode de dépôt de film faisant face au dit substrat sont incurvés avec un rayon de courbure d'au moins 2 mm.

7. Dispositif de dépôt de film selon l'une quelconque des revendications 1 à 6, comprenant en outre un deuxième blindage mis à la masse qui est disposé dans la direction plane dudit substrat de manière à entourer ledit blindage mis à la masse.

8. Dispositif de dépôt de film selon la revendication 7, dans lequel une distance des extrémités côté substrat dudit deuxième blindage mis à la masse au dit substrat est égale ou inférieure à une distance des extrémités côté substrat de ladite électrode de dépôt de film au dit substrat dans une région entière dudit deuxième blindage mis à la masse.

9. Dispositif de dépôt de film selon l'une quelconque des revendications 1 à 8,
dans lequel ladite électrode de dépôt de film comporte un espace d'alimentation en gaz qui est formé à l'intérieur et des trous d'alimentation en gaz qui sont formés dans une surface de ladite électrode de dépôt de film faisant face au dit substrat et qui communiquent avec ledit espace d'alimentation en gaz, et
dans lequel lesdits moyens d'alimentation en gaz délivrent lesdits gaz de dépôt de film au dit espace d'alimentation en gaz.

10. Dispositif de dépôt de film selon l'une quelconque des revendications 1 à 9, dans lequel lesdits moyens de transport transportent ledit substrat en l'enroulant autour d'une région prédéterminée d'une surface périphérique d'un tambour cylindrique qui sert en tant que dite contre-électrode.

11. Dispositif de dépôt de film selon la revendication 10, dans lequel une surface de ladite électrode de dépôt de film faisant face au dit substrat est incurvée de manière à être parallèle à ladite surface périphérique dudit tambour.
